# EUROPÄISCHE PATENTSCHRIFT

(11) **EP 0 985 271 B1**
(45) Veröffentlichungstag und Bekanntmachung des Hinweises auf die Patenterteilung: **24.10.2001**
(21) Anmeldenummer: 98931953.8
(22) Anmeldetag: 20.04.1998
(51) Int. Cl.: H03K 19/0185

(54) **EINGANGSSCHALTUNG FÜR EINE INTEGRIERTE SCHALTUNG**
INPUT CIRCUIT FOR AN INTEGRATED CIRCUIT
CIRCUIT D'ENTREE POUR CIRCUIT INTEGRE

(30) Priorität: 27.05.1997 DE 19722158
(43) Veröffentlichungstag der Anmeldung: 15.03.2000
(73) Patentinhaber: Infineon Technologies AG, 81669 München (DE)
(72) Erfinder: BUCK, Martin, D-81243 München (DE)
(74) Vertreter: Zedlitz, Peter, Dipl.-Inf.
(86) Internationale Anmeldenummer: DE9801098
(87) Internationale Veröffentlichungsnummer: WO9854839

(56) Entgegenhaltungen:
- EP-A- 0 105 685
- US-A- 4 745 305
- US-A- 5 455 524
- PATENT ABSTRACTS OF JAPAN vol. 012, no. 069 (E-587), 3. März 1988 & JP 62 210727 A (FUJITSU LTD), 16. September 1987
- "CMOS SELECTABLE NAND-NOR CIRCUIT" IBM TECHNICAL DISCLOSURE BULLETIN, Bd. 33, Nr. 3B, 1. August 1990, Seiten 385-387, XP000124400

## Beschreibung

Die Erfindung betrifft eine Eingangsschaltung für eine integrierte Schaltung.

Eingangsschaltungen integrierter Schaltungen für digitale Signale, die zwei Pegel aufweisen, die in der Nähe von zwei Versorgungspotentialen der Eingangsschaltung liegen, werden häufig mittels eines Inverters realisiert. Derartige Eingangssignale (im folgenden "Standard-Digitalsignale" genannt) treten beispielsweise bei der sogenannten TTL-Logik beziehungsweise LVTTL-Logik (Low Voltage TTL) auf.

Anderen integrierten Schaltungen werden dagegen Eingangssignale zugeführt, die zwei Pegel aufweisen, die gegenüber einem Referenzpegel jeweils eine positive beziehungsweise negative Differenz darstellen. Für derartige Eingangssignale (im folgenden "Differenzsignalen genannt) können Differenzverstärker als Eingangsschaltungen eingesetzt werden, denen als Vergleichswert der Referenzpegel zugeführt wird, während an ihrem Eingang das Eingangssignal anliegt. Derartige Differenzsignale kommen beispielsweise bei der sogenannten SSTL-Logik zum Einsatz. Für die SSTL-Logik sind typische Werte dess Referenzpegels 1,4 V und für den negativen Pegel 1,44 V - 0,3 V sowie für den positiven Pegel 1,4 V + 0,3 V.

In der US 5,455,524A ist eine Eingangsschaltung beschrieben, die eine Reihenschaltung zweier Inverter und eine Reihenschaltung zweier Differenzverstärker aufweist. In einer ersten Betriebsart sind die beiden Differenzverstärker aktiviert und die Inverter deaktiviert, und der Schaltung werden ECL-Einganssignale zugeführt. In einer zweiten Betriebsart sind die Differenzverstärker deaktiviert und die Inverter aktiviert, und der Schaltung werden CMOS-Einganssignale zugeführt. Die Differenzverstärker und Inverter sind jeweils durch unterschiedliche Bauelemente realisiert.

Der Erfindung liegt die Aufgabe zugrunde, eine Eingangsschaltung für zwei unterschiedliche Eingangspegel anzugeben, die mit relativ wenigen Bauelementen realisierbar ist.

Der Erfindung liegt die Aufgabe zugrunde, eine Eingangsschaltung anzugeben, die vielseitig einsetzbar ist.

Diese Aufgabe wird mit einer Eingangsschaltung gemäß Patentanspruch 1 gelöst. Weiterbildungen und Ausgestaltungen der Erfindung sind in den Unteransprüchen gekennzeichnet.

Die erfindungsgemäße Eingangsschaltung weist sowohl einen Inverter als auch einen Differenzverstärker auf, die jeweils eingangsseitig mit dem Eingang und ausgangsseitig mit dem Ausgang der Eingangsschaltung verbunden sind. Die Eingangsschaltung hat zwei Betriebsarten, wobei in Abhängigkeit eines Aktivierungssignals in der ersten Betriebsart der Differenzverstärker aktiviert und der Inverter deaktiviert ist und in der zweiten Betriebsart der Differenzverstärker deaktiviert und der Inverter aktiviert ist. In der ersten Betriebsart ist also lediglich der Differenzverstärker wirksam und in der zweiten Betriebsart der Inverter. Somit können in der ersten Betriebsart Differenzsignale (beispielsweise mit SSTL-Pegel) an den Eingang der Eingangsschaltung angelegt werden und in der zweiten Betriebsart Standard-Digitalsignale (beispielsweise mit TTL-Pegel).

Eine Weiterbildung der Erfindung sieht vor, daß ein dem Differenzverstärker zuführbares Referenzsignal in den beiden Betriebsarten unterschiedliche Pegel aufweist und das Aktivierungssignal vom Referenzsignal abgeleitet ist. Im einfachsten Fall kann dabei beispielsweise das Aktivierungssignal gleich dem Referenzsignal sein. Es ist jedoch auch möglich, daß das Aktivierungssignal invers zum Referenzsignal ist beziehungsweise zur Erzeugung höherer Pegel des Aktivierungssignals aus dem Referenzsignal durch Verstärkung erzeugt wird. Das Ableiten des Aktivierungssignals aus dem Referenzsignal bietet den Vorteil, daß der Eingangsschaltung lediglich eines dieser beiden Signale zugeführt werden muß. Beispielsweise bei der SSTL-Logik ist es oftmals ohnehin vorgesehen, das benötigte Referenzsignal extern, das heißt Off-Chip, zur Verfügung zu stellen, um den Pegel des Referenzsignals in einfacher Weise ändern zu können.

Die Erfindung wird im folgenden anhand der Figuren näher erläutert. Es zeigen:
- Figur 1: ein Ausführungsbeispiel der Erfindung,
- Figur 2: eine Schaltung zur Erzeugung des Aktivierungssignals aus dem Referenzsignal und
- Figur 3: den Verlauf der in Figur 2 dargestellten Signale in Abhängigkeit vom Wechseln zwischen den beiden Betriebsarten der Eingangsschaltung.

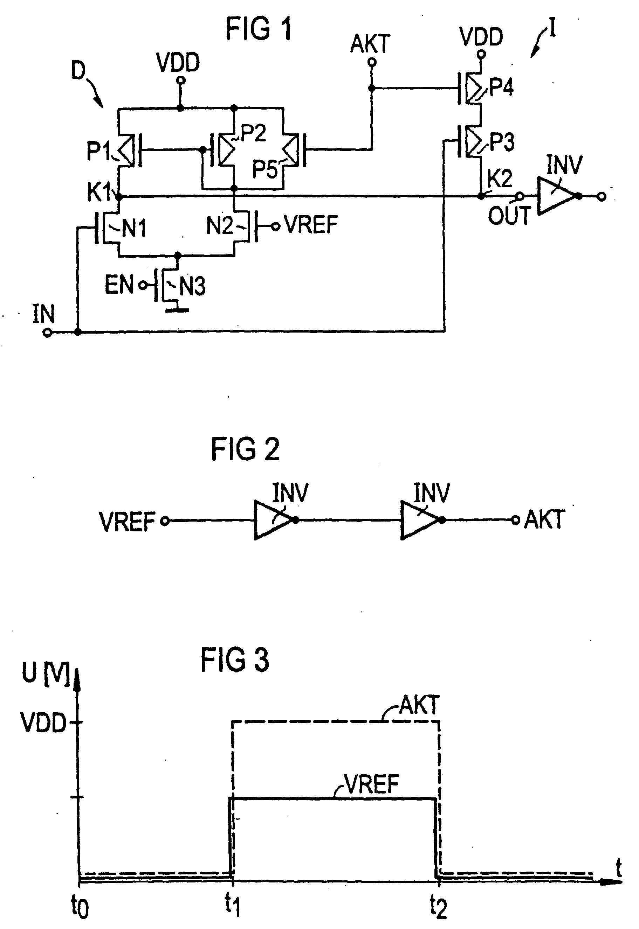

Figur 1 zeigt einen Differenzverstärker D, der zwei p-Kanal-Transistoren P1, P2 und zwei n-Kanal-Transistoren N1, N2 aufweist. Das Gate des ersten n-Kanal-Transistors N1 ist der Eingang des Differenzverstärkers, der mit einem Eingang IN der Eingangsschaltung verbunden ist. Das Gate des zweiten n-Kanal-Transistors N2 ist mit einem Referenzsignal VREF, das der Eingangsschaltung von extern zuführbar ist, verbunden.

Zusätzlich ist ein dritter n-Kanal-Transistor N3 vorhanden, an dessen Gate ein Inbetriebnahmesignal beziehungsweise Enable-Signal EN anlegbar ist, welches zur Aktivierung beziehungsweise Deaktivierung der gesamten Eingangsschaltung dient. Obwohl das Vorsehen des dritten n-Kanal-Transistors N3 an der beschriebenen Stelle eine einfache und sichere Deaktivierung und Aktivierung der gesamten Eingangsschaltung ermöglicht, kann dieser bei anderen Ausführungsformen der Erfindung entfallen beziehungsweise durch an anderer Stelle vorgesehene Enable-Schaltungskomponenten ersetzt werden.

Weiterhin weist die in Figur 1 dargestellte Eingangsschaltung einen Inverter I auf in Form eines CMOS-Inverters, der durch einen dritten p-Kanal-Transistor P3 und den ersten n-Kanal-Transistor N1 des Differenzverstärkers D gebildet ist. Die Gates dieser beiden Transistoren P3, N1 sind ebenfalls mit dem Eingang IN der Eingangsschaltung verbunden und bilden den Eingang des Inverters I.

Der Ausgang K1 des Differenzverstärkers D und der Ausgang K2 des Inverters I sind beide mit einem Ausgang OUT der Eingangsschaltung verbunden. Differenzverstärker D und Inverter I sind also bezüglich des Eingangs IN und des Ausgangs OUT der Eingangsschaltung parallel geschaltet. Dem Ausgang OUT ist ein weiterer Inverter INV nachgeschaltet, der einer Verstärkung des Signals am Ausgang OUT dient und bei anderen Ausführungsbeispielen der Erfindung auch entfallen kann.

Die Eingangsschaltung in Figur 1 weist weiterhin ein Aktivierungssignal AKT auf, mittels dessen in einer ersten Betriebsart der Eingangsschaltung der Differenzverstärker D aktiviert und der Inverter I deaktivert und in einer zweiten Betriebsart der Differenzverstärker D deaktiviert und der Inverter I aktivert wird. Um die Aktivierung beziehungsweise Deaktivierung des Inverters I zu realisieren, weist dieser zwischen dem zweiten Versorgungspotential VDD und seinem p-Kanal-Transistor P3 einen vierten p-Kanal-Transistor P4 auf, dessen Gate mit dem Aktivierungssignal AKT verbunden ist. Die zur Aktivierung bzw. Deaktivierung des Inverters I inverse Aktivierung bzw. Deaktivierung des Differenzverstärkers D erfolgt mittels eines fünften p-Kanal-Transistors P5, der mit seinem stromführenden Pfad parallel zu demjenigen des zweiten p-Kanal-Transistors P2 geschaltet ist. Das Gate des fünften p-Kanal-Transistors P5 ist wiederum mit dem Aktivierungssignal AKT verbunden.

Figur 2 zeigt eine Schaltung, mit der das Aktivierungssignal AKT mittels zweier in Reihe geschalteter Inverter INV aus dem Referenzsignal VREF abgeleitet wird. Anstelle von Invertern kann die erforderliche Verstärkung auch auf andere Weise erzielt werden, z.B. mittels eines Differenzverstärkers.

Figur 3 zeigt den der Schaltung aus Figur 2 zugehörigen Signalverlauf des Referenzsignals VREF und des Aktivierungssignals AKT. Zwischen den Zeitpunkten t₀ und t₁ befindet sich die Eingangsschaltung in der zweiten Betriebsart. Das extern zugeführte Referenzsignal VREF hat Massepotential, da es für die zweite Betriebsart nicht benötigt wird. Folglich weist auch das aus dem Referenzsignal VREF durch Verstärkung gewonnene Aktivierungssignal AKT Massepotential auf. Durch das Massepotential des Referenzsignals VREF ist der zweite n-Kanal-Transistor N2 des Differenzverstärkers D gesperrt. Es kann daher in der zweiten Betriebsart kein Strom über diesen fließen, selbst wenn der Enable-Transistor N3 über das Enable-Signal EN leitend geschaltet ist. Da auch das Aktivierungssignal AKT in der zweiten Betriebsart Massepotential aufweist, ist der fünfte p-Kanal-Transistor P5 leitend geschaltet und überbrückt damit den zweiten p-Kanal-Transistor P2 des Differenzverstärkers D. Daher liegt das zweite Versorgungspotential VDD in der zweiten Betriebsart auch am Gate des ersten p-Kanal-Transistors P1, wodurch dieser sicher sperrt. Es kann dann kein Strom über den ersten p-Kanal-Transistor P1 vom zweiten Versorgungspotential VDD zum Ausgang OUT der Eingangsschaltung fließen.

Das Massepotential des Aktivierungssignals AKT in der zweiten Betriebsart bewirkt gleichzeitig zur soeben beschriebenen Deaktivierung des Differenzverstärkers D, daß der vierte p-Kanal-Transistor P4 leitend geschaltet wird. Der aus dem dritten p-Kanal-Transistor P3 und dem ersten n-Kanal-Transistor N1 bestehende Inverter I ist somit aktiviert und zum Empfang von Eingangssignalen mit TTL-Pegel am Eingang IN der Eingangsschaltung bereit, während der Differenzverstärker D deaktiviert ist.

Figur 3 zeigt zwischen den Zeitpunkten t₁ und t₂ die Pegel des Referenzsignals VREF und des Aktivierungssignals AKT während der ersten Betriebsart der Eingangsschaltung. Das extern zugeführte Referenzsignal VREF muß für einen sinnvollen Vergleich durch den Differenzverstärker D kleiner als das zweite Versorgungspotential VDD und größer als die Einsatzspannung des zweiten n-Kanal-Transistors N2 sein. Im vorliegenden Fall ist sein High-Pegel etwa halb so groß wie VDD. Durch Verstärkung gemäß Figur 2 weist das Aktivierungssignal AKT einen High-Pegel der Höhe VDD auf. Folglich ist sowohl der vierte p-Kanal-Transistor P4 gesperrt, wodurch der Inverter I deaktiviert ist, als auch der fünfte p-Kanal-Transistor P5, so daß der zweite p-Kanal-Transistor P2 des Differenzverstärkers D in der ersten Betriebsart nicht überbrückt ist. Der Differenzverstärker D ist also in der ersten Betriebsart aktiviert und zum Empfang von Differenzsignalen am Eingangsschaltung IN der Eingangsschaltung bereit.

Nach dem Zeitpunkt t₂ in Figur 3 ist der Signalverlauf für einen erneuten Wechsel von der ersten Betriebsart zur zweiten Betriebsart eingezeichnet.

Die Eingangsschaltung in Figur 1 weist den Vorteil auf, daß durch gemeinsame Nutzung des ersten n-Kanal-Transistors N1 durch den Differenzverstärker D (in der ersten Betriebsart) und den Inverter I (in der zweiten Betriebsart) nur wenige Schaltungskomponenten zu ihrer Realisierung benötigt werden. Für die wechselweise Aktivierung/Deaktivierung des Differenzverstärkers D und des Inverters I werden nur zwei p-Kanal-Transistoren P4, P5 und das digitale Aktivierungssignal AKT benötigt. Dabei ist gewährleistet, daß in der zweiten Betriebsart kein statischer Verluststrom fließt, wenn das entsprechende Eingangssignal am Eingang IN Pegel aufweist, die jeweils in der Nähe eines der Versorgungspotentiale VDD, Masse liegen. Dann ist nämlich ein Öffnen eines der beiden Transistoren P3; N1, die den Inverter I bilden, und gleichzeitiges vollständiges Sperren des jeweils anderen Transistors N1; P3 bei entsprechender Dimensionierung der Transistoren P3, N1 gewährleistet.

## Patentansprüche

1. Eingangsschaltung mit einem Eingang (IN) und einem Ausgang (OUT)
- mit einem Inverter (I) und einem Differenzverstärker (D), die jeweils eingangsseitig mit dem Eingang (IN) und ausgangsseitig mit dem Ausgang (OUT) der Eingangsschaltung verbunden sind,
- mit zwei Betriebsarten, wobei in Abhängigkeit eines Aktivierungssignals (AKT) in der ersten Betriebsart der Differenzverstärker (D) aktiviert und der Inverter (I) deaktiviert ist und in der zweiten Betriebsart der Differenzverstärker (D) deaktiviert und der Inverter (I) aktiviert ist,
- bei der der Differenzverstärker (D) zwischen einem ersten und einem zweiten Versorgungspotential (Masse, VDD) in einer ersten Reihenschaltung wenigstens einen ersten Transistor eines ersten Kanaltyps (P1) und einen ersten Transistor eines zweiten Kanaltyps (N1) und in einer zweiten Reihenschaltung wenigstens einen zweiten Transistor des ersten Kanaltyps (P2) und einen zweiten Transistor des zweiten Kanaltyps (N2) aufweist,
- wobei die Gates der beiden Transistoren vom ersten Kanaltyp (P1, P2) miteinander verbunden sind,
- wobei Gate und Drain des zweiten Transistors vom ersten Kanaltyp (P2) miteinander verbunden sind,
- wobei das Gate des ersten Transistors des zweiten Kanaltyps (N1) der Eingang des Differenzverstärkers (D) ist,
- wobei das Gate des zweiten Transistors des zweiten Kanaltyps (N2) mit einem Referenzsignalanschluß (VREF) verbunden ist,
- wobei ein Schaltungsknoten (K1) zwischen dem ersten Transistor des ersten Kanaltyps (P1) und dem ersten Transistor des zweiten Kanaltyps (N1) der Ausgang des Differenzverstärkers (D) ist,
- und bei der der Inverter (I) zwischen den beiden Versorgungspotentialen (Masse, VDD) eine Reihenschaltung aus wenigstens einem dritten Transistor des ersten Kanaltyps (P3) und dem ersten Transistor des zweiten Kanaltyps (N1) aufweist,
- wobei ein Schaltungsknoten (K2) zwischen diesen beiden Transistoren (P3, N1) der Ausgang des Inverters (I) ist,
- wobei die Gates dieser beiden Transistoren (P3, N1) den Eingang des Inverters (I1) bilden.

2. Eingangsschaltung nach Anspruch 1,
bei der die erste und die zweite Reihenschaltung des Differenzverstärkers (D) über ein gemeinsames erstes Schaltelement (N3) mit dem ersten Versorgungspotential (Masse) verbunden sind, das einen Steuereingang hat, der mit einem Inbetriebnahmesignal (EN) der Eingangsschaltung verbunden ist.

3. Eingangsschaltung nach einem der Ansprüche 1 oder 2,
bei der der dritte Transistor des ersten Kanaltyps (P3) über ein zweites Schaltelement (P4) mit dem zweiten Versorgungspotential (VDD) verbunden ist, das einen Steuereingang hat, der mit dem Aktivierungssignal (AKT) verbunden ist.

4. Eingangsschaltung nach Anspruch 3,
bei der das zweite Schaltelement (P4) ein vierter Transistor des ersten Kanaltyps ist.

5. Eingangsschaltung nach einem der Ansprüche 1 bis 4,
bei der der zweite Transistor des ersten Kanaltyps (P2) mit seinem stromführenden Pfad parallel zu einem dritten Schaltelement (P5) angeordnet ist, das einen Steuereingang hat, der' mit dem Aktivierungssignal (AKT) verbunden ist.

6. Eingangsschaltung nach Anspruch 5,
bei der das dritte Schaltelement (P5) ein fünfter Transistor des ersten Kanaltyps ist.

7. Eingangsschaltung nach einem der Ansprüche 1 bis 6,
- bei der dem Differenzverstärker (D) ein Referenzsignal (VREF) zugeführt wird, das in den beiden Betriebsarten unterschiedliche Pegel aufweist,
- und bei der das Aktivierungssignal (AKT) vom Referenzsignal (VREF) abgeleitet ist.

8. Eingangsschaltung nach Anspruch 7,
bei der das Aktivierungssignal (AKT) durch Verstärkung des Referenzsignals (VREF) erzeugt wird.

9. Eingangsschaltung nach einem der Ansprüche 7 oder 8,
bei der das Referenzsignal (VREF) in der zweiten Betriebsart den Wert des ersten Versorgungspotentials (Masse) des Differenzverstärkers (D) und in der ersten Betriebsart einen Wert zwischen dem ersten (Masse) und dem zweiten (VDD) Versorgungspotential des Differenzverstärkers (D) annimmt.

## Claims

1. An input circuit having an input (IN) and an output (OUT),
- having an inverter (I) and a differential amplifier (D), which are respectively connected on the input side to the input (IN) and on the output side to the output (OUT) of the input circuit,
- having two operating modes, with, on the basis of an activation signal (ACT), the differential amplifier (D) being activated and the inverter (I) being deactivated in the first operating mode, and the differential amplifier (D) being deactivated and the inverter (I) being activated in the second operating mode,
- in which the differential amplifier (D) has, between the first and the second supply potential (ground, VDD) in a first series circuit, at least one first transistor of a first channel type (P1) and one first transistor of a second channel type (N1), and, in a second series circuit, at least one second transistor of the first channel type (P2) and one second transistor of the second channel type (N2),
- the gates of the two transistors of the first channel type (P1, P2) being connected to one another,
- the gate and drain of the second transistor of the first channel type (P2) being connected to one another,
- the gate of the first transistor of the second channel type (N1) being the input of the differential amplifier (D),
- the gate of the second transistor of the second channel type (N2) being connected to a reference signal terminal (VREF),
- a circuit node (K1) between the first transistor of the first channel type (P1) and the first transistor of the second channel type (N1), being the output of the differential amplifier (D),
- and in which the inverter (IN) has, between the two supply potentials (ground, VDD), a series circuit comprising at least one third transistor of the first channel type (P3) and the first transistor of the second channel type (N1),
- the circuit node (K2) between these two transistors (P3, N1) being the output of the inverter (I),
- the gates of these two transistors (P3, N1) forming the input of the inverter (1).

2. The input circuit as claimed in claim 1, in which the first and second series circuits of the differential amplifier (D) are connected to the first supply potential (ground) through a shared first switching element (N3) which has a control input that has an enable signal (EN) of the input circuit applied to it.

3. The input circuit as claimed in one of claims 1 and 2, in which the third transistor of the first channel type (P3) is connected to the second supply potential (VDD) through a second switching element (P4) which has a control input that has the activation signal (ACT) applied to it.

4. The input circuit as claimed in claim 3, in which the second switching element (P4) is a fourth transistor of the first channel type.

5. The input circuit as claimed in one of claims 1 to 4, in which the second transistor of the first channel type (P2) is arranged with its current-carrying path in parallel with a third switching element (P5) which has a control input that has the activation signal (ACT) applied to it.

6. The input circuit as claimed in claim 5, in which the third switching element (P5) is a fifth transistor of the first channel type.

7. The input circuit as claimed in one of claims 1 to 6,
- in which a reference signal (VREF) that has different levels in the two operating modes is applied to the differential amplifier (D),
- and in which the activation signal (ACT) is derived from the reference signal (VREF).

8. The input circuit as claimed in claim 7, in which the activation signal (ACT) is produced by amplifying the reference signal (VREF).

9. The input circuit as claimed in one of claims 7 and 8, in which the reference signal (VREF) takes the value of the first supply potential (ground) of the differential amplifier (D) in the second operating mode, and a value between the first (ground) and second (VDD) supply potentials of the differential amplifier (D) in the first operating mode.

## Revendications

1. Circuit d'entrée comportant une entrée (IN) et une sortie (OUT),
- comportant un inverseur (I) et un amplificateur (D) différentiel qui sont reliés chacun côté entrée à l'entrée (IN) et côté sortie à la sortie (OUT) du circuit d'entrée,
- comportant deux modes de fonctionnement, en fonction d'un signal (AKT) d'activation, l'amplificateur (D) différentiel étant activé et l'inverseur (I) étant désactivé en le premier mode de fonctionnement et l'amplificateur (D) différentiel étant désactivé et l'inverseur (I) étant activé en le second mode de fonctionnement,
- dans lequel l'amplificateur (D) différentiel comporte entre un premier et un deuxième potentiel (masse, VDD) d'alimentation, dans un premier circuit série, au moins un premier transistor d'un premier type (P1) de canal et un premier transistor d'un deuxième type (N1) de canal et, dans un deuxième circuit série, au moins un deuxième transistor du premier type (P2) de canal et un deuxième transistor du deuxième type (N2) de canal,
- les grilles des deux transistors du premier type (P1, P2) de canal étant reliées entre elles,
- la grille et le drain du deuxième transistor du premier type (P2) de canal étant reliés entre eux;
- la grille du premier transistor du deuxième type (N1) de canal étant l'entrée de l'amplificateur (D) différentiel,
- la grille du deuxième transistor du deuxième type (N2) de canal étant reliée à une borne (VREF) de signal de référence,
- un noeud (K1) du circuit entre le premier transistor du premier type (P1) de canal et le premier transistor du deuxième type (N1) de canal étant la sortie de l'amplificateur (D) différentiel,
- et dans lequel l'inverseur (I) comporte entre les deux potentiels (masse, VDD) d'alimentation un circuit série constitué d'au moins un troisième transistor du premier type (P3) de canal et le premier transistor du deuxième type (N1) de canal,
- un noeud (K2) du circuit entre ces deux transistors (P3, N1) étant la sortie de l'inverseur (I),
- les grilles de ces deux transistors (P3, N1) formant l'entrée de l'inverseur (I).

2. Circuit d'entrée suivant la revendication 1, dans lequel le premier et le second circuit série de l'amplificateur (D) différentiel sont reliés au premier potentiel (masse) d'alimentation par l'intermédiaire d'un premier élément (N3) de commutation commun qui a une entrée de commande qui est reliée à un signal (EN) de mise en marche du circuit d'entrée.

3. Circuit d'entrée suivant l'une des revendications 1 ou 2, dans lequel le troisième transistor du premier type (P3) de canal est relié au deuxième potentiel (VDD) d'alimentation par l'intermédiaire d'un deuxième élément (P4) de commutation qui a une entrée de commande qui est reliée au signal (AKT) d'activation.

4. Circuit d'entrée suivant la revendication 3, dans lequel le deuxième élément (P4) de commutation est un quatrième transistor du premier type de canal.

5. Circuit d'entrée suivant l'une des revendications 1 à 4, dans lequel le deuxième transistor du premier type (P2) de canal est monté par sa voie guidant le courant en parallèle à un troisième élément (P5) de commutation qui a une entrée de commande qui est reliée au signal (AKT) d'activation.

6. Circuit d'entrée suivant la revendication 5, dans lequel le troisième élément (P5) de commutation est un cinquième transistor du premier type de canal.

7. Circuit d'entrée suivant l'une des revendications 1 à 6,
- dans lequel il est envoyé à l'amplificateur (D) différentiel un signal (VREF) de référence qui a des niveaux différents dans les deux modes de fonctionnement,
- et dans lequel le signal (AKT) d'activation est dérivé du signal (VREF) de référence.

8. Circuit d'entrée suivant la revendication 7, dans lequel le signal (AKT) d'activation est produit par amplification du signal (VREF) de référence.

9. Circuit d'entrée suivant l'une des revendications 7 ou 8, dans lequel le signal (VREF) de référence prend dans les deux modes de fonctionnement la valeur du premier potentiel (masse) d'alimentation de l'amplificateur (D) différentiel et en le premier mode de fonctionnement une valeur entre le premier potentiel (masse) d'alimentation et le deuxième potentiel (VDD) d'alimentation de l'amplificateur (D) différentiel.
